# EUROPEAN PATENT APPLICATION

(11) **EP 4 626 189 A1**
(43) Date of publication of application: **01.10.2025**
(21) Application number: 25165227.7
(22) Date of filing: 21.03.2025
(51) Int. Cl.: H10H 29/14, H10H 29/37, H10H 29/85, H10H 29/853, H10H 29/855, H10H 29/856

(54) **LIGHT-EMITTING DEVICE AND PLANAR LIGHT SOURCE**

(30) Priority: 28.03.2024 JP 2024054047
(71) Applicant: NICHIA CORPORATION, Anan-shi, Tokushima 774-8601 (JP)
(72) Inventor: KAYAMA, Kiyoshi, Anan-shi, Tokushima, 774-8601 (JP)
(74) Representative: Winter, Brandl - Partnerschaft mbB

(57) **Abstract**

A light-emitting device includes: a substrate; a light-emitting element located on the substrate; a light-transmitting member covering the light-emitting element; and a light-shielding member located on the light-transmitting member, the light-shielding member shielding at least a portion of light emitted from the light-emitting element. The light-transmitting member includes: an upper surface on which the light-shielding member is located, and a lateral surface including an inclined portion, the inclined portion being connected to the upper surface. The substrate includes a wall part positioned at a lateral side of the light-emitting element. An upper end of the wall part is positioned lower than an upper surface of the light-emitting element.

## Description

### CROSS-REFERENCE TO RELATED APPLICATION

This application claims priority to Japanese Patent Application No. 2024-054047, filed on March 28, 2024, the disclosure of which is hereby incorporated by reference in its entirety.

### BACKGROUND

The present disclosure relates to a light-emitting device and a planar light source.

Technology related to light distribution properties of light emitted from light-emitting devices are being developed. For example, Japanese Patent Publication No. 2015-50468 discusses a light-emitting device having higher directivity.

### SUMMARY

An object of embodiments according to the disclosure is to provide a light-emitting device that can emit light with a wide light distribution, and a planar light source including the light-emitting device.

In an embodiment of the present disclosure, a light-emitting device includes a substrate; a light-emitting element located on the substrate; a light-transmitting member placed to cover the light-emitting element; and a light-shielding member located on the light-transmitting member, the light-shielding member shielding at least a portion of light emitted from the light-emitting element, the light-transmitting member including an upper surface on which the light-shielding member is located, and a lateral surface including an inclined portion connected to the upper surface, the substrate including a wall part positioned at a side of the light-emitting element, the wall part including an upper end positioned lower than an upper surface of the light-emitting element.

According to certain embodiments of the present disclosure, a light-emitting device that can emit light with a wide light distribution, and a planar light source including the light-emitting device can be provided.

### BRIEF DESCRIPTION OF THE DRAWINGS

FIG. 1 is a schematic perspective view of a light-emitting device according to a first embodiment;
FIG. 2 is a schematic cross-sectional view along line II-II of FIG. 1;
FIG. 3 is a schematic cross-sectional view along a XZ-plane of a light-emitting device according to a modification 1;
FIG. 4 is a schematic cross-sectional view along a XZ-plane of a light-emitting device according to a modification 2;
FIGS. 5 and 6 are schematic perspective views of a light-emitting device according to a third embodiment;
FIG. 7 is a schematic plan view of a planar light source according to the third embodiment;
FIG. 8 is a cross-sectional view along line VIII-VIII of FIG. 7; and
FIG. 9 is a cross-sectional view along line IX-IX of FIG. 7.

### DETAILED DESCRIPTION

A light-emitting device according to an embodiment of the disclosure will now be described with reference to the drawings. The following embodiments illustrate a light-emitting device that embodies technical concepts of the invention, but the invention is not limited to the described embodiments. Unless specifically stated, the dimensions, material properties, shapes, relative arrangements, and the like of the components according to the embodiments are not intended to limit the scope of the disclosure to those only, and are merely illustrative examples. The sizes, positional relationships, and the like of the members shown in the drawings may be exaggerated for clarity of description. In the following description, the same names and reference numerals refer to the same or similar members; and a detailed description is omitted as appropriate. End views that show only cross sections may be used as cross-sectional views.

In the following description, terms that indicate specific directions or positions (e.g., "upper/above/upward," "lower/below/downward," and other terms related to such terms) may be used. Such terms, however, are used merely for better understanding of relative directions or positions when referring to the drawings. As long as the relationships are the same, the relative directions or positions according to terms such as "upper/above/upward," "lower/below/downward," etc., used when referring to the drawings may not have the same arrangements in drawings, actual products, and the like outside the disclosure. In the specification, when assuming that there are, for example, two members, the positional relationship expressed as "upper/above/upward," "lower/below/downward," or "on" includes the case where the two members are in contact, and the case where the two members are not in contact so that one of the members is positioned above (or below) the other member. "In a plan view" refers to viewing directly or transparently from above (i.e., the positive Z-axis) or from below (i.e., the negative Z-axis). In the specification, unless specifically stated, a member covering a covered object includes the case where the member contacts the covered object and directly covers the covered object, and the case where the member indirectly covers the covered object without contacting the covered object. In the specification, unless otherwise noted, "area" means the area in a plan view.

In the drawings shown below, directions may be indicated using an X-direction, a Y-direction, and a Z-direction. The X-direction, the Y-direction, and the Z-direction are orthogonal to each other. When a plane that includes the X-direction and Y-direction is taken as the XY-plane, the Z-direction is orthogonal to the XY-plane. For example, one side of a substrate is parallel to the X-direction, and another side of the substrate is parallel to the Y-direction.

### 1. First embodiment

### 1.1 Overall structure

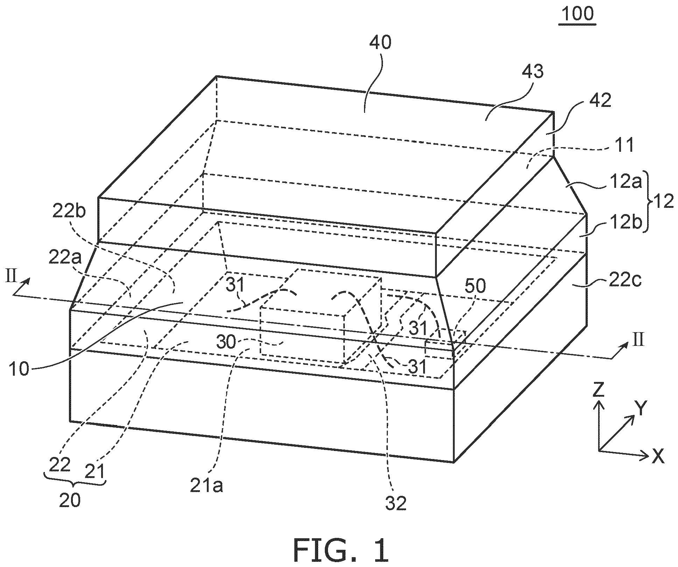

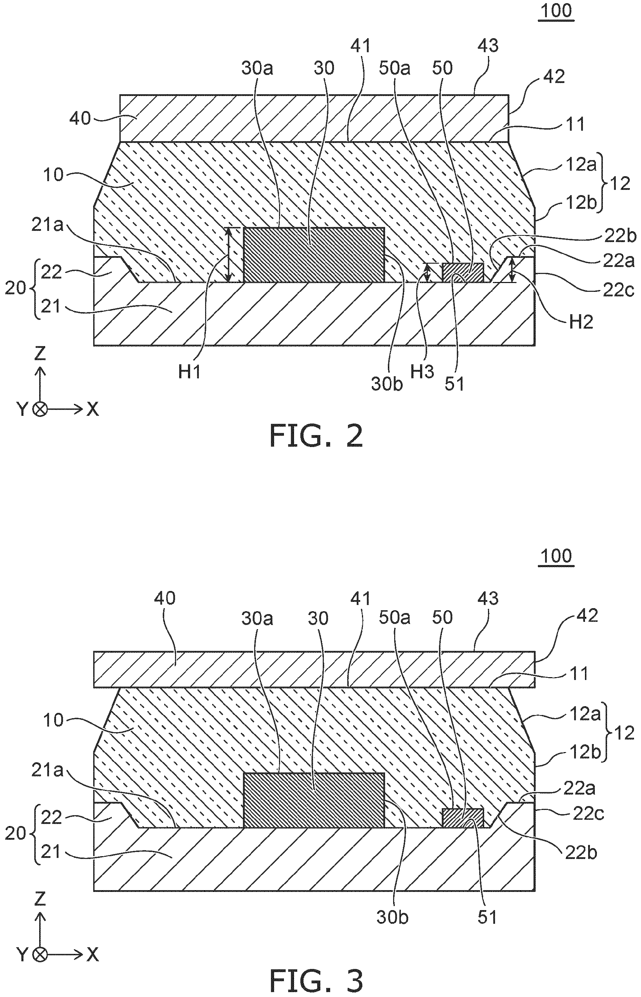

An overall configuration of a light-emitting device 100 according to a first embodiment will now be described with reference to FIGS. 1 and 2.

FIG. 1 is a schematic perspective view of the light-emitting device according to the first embodiment.

FIG. 2 is a schematic cross-sectional view along line II-II of FIG. 1.

The light-emitting device 100 is rectangular in a plan view. As shown in FIG. 1, the light-emitting device 100 includes a substrate 20, a light-emitting element 30 placed on the substrate, a light-transmitting member 10 placed to cover the light-emitting element 30, and a light-shielding member 40 that is located on the light-transmitting member 10 and shields at least a portion of the light emitted from the light-emitting element 30.

The substrate 20 is rectangular in a plan view and includes a base part 21 and a wall part 22. The base part 21 includes a placement surface 21a for placing the light-emitting element. The wall part 22 surrounds the periphery of the light-emitting element 30 while being on the base part 21. According to the embodiment, the outer lateral surface of the wall part 22 is coplanar with the outer lateral surface of the base part 21. One wall part 22 is provided to surround the light-emitting element 30. The wall part 22 is positioned at the lateral side of the light-emitting element 30 placed at the central portion of the placement surface 21a. The wall part 22 includes an upper end 22a positioned lower than an upper surface 30a of the light-emitting element 30. Specifically, a height H1 of the upper surface 30a of the light-emitting element 30 with respect to the placement surface 21a is greater than a height H2 of the wall part 22 with respect to the placement surface 21a. For example, it is preferable for the height H1 of the upper surface 30a of the light-emitting element 30 with respect to the placement surface 21a to be not less than 120 µm and not more than 250 µm, e.g., 200 µm. For example, it is preferable for the height H2 of the wall part 22 with respect to the placement surface 21a to be not less than 70 µm and not more than 200 µm, e.g., 100 µm. By setting the height H1 of the upper surface 30a of the light-emitting element 30 with respect to the placement surface 21a to be greater than the height H2 of the wall part 22 with respect to the placement surface 21a, a portion of the light traveling from the light-emitting element in directions parallel to the XY-plane can be diffusely reflected by the wall part. Also, the light that travels toward the surface of the base body or the like to which the light-emitting device is mounted can be reduced.

The wall part 22 includes an inner lateral surface 22b that faces the light-emitting element 30, and an outer lateral surface 22c that forms the lateral surface of the substrate 20 at the side opposite to the inner lateral surface 22b. The inner lateral surface 22b of the wall part 22 is inclined away from the light-emitting element 30 as the height of the inner lateral surface 22b increases. It is preferable for the angle between the placement surface 21a and the inner lateral surface 22b to be not less than 135° and not more than 175°, e.g., 150°. The angle between the placement surface 21a and the inner lateral surface 22b of the wall part 22 may be 90°.

The light-transmitting member 10 is placed to cover the upper surface 30a and a lateral surface 30b of the light-emitting element 30. The light-transmitting member 10 includes an upper surface 11 and a lateral surface 12, and the light-shielding member 40 is located at the upper surface 11. The upper surface 11 is connected to the lateral surface 12 and is, for example, flat. The upper surface 11 may include a recessed portion. The entire upper surface 11 may be recessed, or the upper surface 11 may include a flat surface and a recessed portion surrounded with the flat surface. The lateral surface 12 includes an inclined portion 12a that is connected to the upper surface 11, and a lateral portion 12b that is connected to the inclined portion 12a and has a larger inclination angle than the inclined portion 12a. As an example, the lateral portion 12b may be a surface parallel to the vertical direction (i.e., the Z-direction). In such a case, the light-transmitting member 10 includes a quadrilateral prism-shaped lower part and a quadrilateral pyramid frustum-shaped upper part. The lateral surface of the upper part corresponds to the inclined portion 12a. The lateral surface of the lower part corresponds to the lateral portion 12b. The lateral portion 12b may have a shape in which, instead of the quadrilateral pyramid frustum-shaped upper part, the upper part is continuous from the quadrilateral prism-shaped lower part such that the corners of the upper part gradually disappear toward the light-shielding member 40 so that the upper surface of the upper part is circular. The height of the boundary between the lower part and the upper part of the light-transmitting member 10 from the placement surface 21a is preferably greater than at least the height of the upper surface of the light-emitting element 30.

The light-shielding member 40 is located on the upper surface 11 of the light-transmitting member 10. The area of a lower surface 41 of the light-shielding member 40 is substantially equal to the area of the upper surface 11 of the light-transmitting member in a plan view. As an example, the light-shielding member 40 has a quadrilateral plate shape in a plan view and includes a lateral surface 42 that is perpendicular to the lower surface 41 or inclined. It is preferable for the thickness of the light-shielding member 40 to be, for example, not less than 100 µm and not more than 600 µm, e.g., 400 µm.

A protection element 50 is located on the placement surface 21a of the substrate 20. An upper surface 51 of the protection element 50 is positioned lower than the upper end 22a of the wall part 22. Specifically, a height H3 of the upper surface of the protection element 50 with respect to the placement surface 21a is less than the height H2 of the wall part 22 with respect to the placement surface 21a. It is preferable for the height H3 of the upper surface of the protection element 50 with respect to the placement surface 21a to be not less than 50 µm and not more than 150 µm, e.g., 100 µm.

The substrate 20 includes a conductive member 32 located at the upper surface of the base part 21. The conductive member 32 is electrically connected with the light-emitting element 30 and supplies power to the light-emitting element 30. It is sufficient for the materials of the base part 21 and the wall part 22 to be insulative and isolate at least a pair of conductive members 32. Examples of the materials include a ceramic, a resin, a composite material, etc. Examples of the resin include a phenol resin, an epoxy resin, a polyimide resin, a BT resin, polyphthalamide (PPA), polyethylene terephthalate (PET), etc. Examples of the composite material include the resin described above into which an inorganic filler such as glass fibers, silicon oxide, titanium oxide, aluminum oxide, or the like is mixed, a glass fiber-reinforced resin (glass epoxy), a metal substrate in which an insulating layer covers a metal member, etc.

### 1.2 Light-transmitting member 10

The light-transmitting member 10 is made of or includes a light-transmitting base material. According to the disclosure, "light-transmitting" refers to the transmittance with respect to the peak wavelength of the light-emitting element being not less than 50%. When the light-emitting device 100 includes multiple light-emitting elements, it is sufficient for the transmittance to be not less than 50% with respect to the peak wavelength of at least one light-emitting element.

For example, a resin material can be used as the base material of the light-transmitting member 10. A thermosetting resin is preferable as the resin used as the base material of the light-transmitting member 10. Examples of the thermosetting resin include an epoxy resin, a modified epoxy resin, a silicone resin, a modified silicone resin, an acrylate resin, a urethane resin, a fluoric resin, etc. Among these resins, the silicone resin and the modified silicone resin have good heat resistance and light resistance and are therefore preferable. For example, a phenyl silicone resin or a dimethyl silicone resin can be used as the base material of the light-transmitting member 10.

The light-transmitting member 10 may include a light-reflective substance. As a result, adjustment of the light distribution of the light-emitting device 100 is easier. As the light-reflective substance, it is preferable to use a member that does not easily absorb light from the light-emitting element 30 and has a large refractive index difference with the base material. Examples of such a light-reflective substance include titanium oxide, zinc oxide, silicon oxide, zirconium oxide, aluminum oxide, aluminum nitride, etc.

The light-transmitting member 10 may include a wavelength conversion member. As a result, color adjustment of the light from the light-emitting device 100 is easier. One or multiple types of wavelength conversion members may be included in the light-transmitting member 10. The phosphor that is included in the light-transmitting member 10 may be dispersed or may be unevenly distributed.

The wavelength conversion member that is included in the light-transmitting member 10 can include a known phosphor. Examples of the phosphor include an yttrium-aluminum-garnet-based phosphor (e.g., Y₃(Al, Ga)₅O₁₂:Ce), a lutetium-aluminum-garnet-based phosphor (e.g., Lu₃(Al, Ga)_{S}O₁₂:Ce), a terbium-aluminum-garnet-based phosphor (e.g., Tb₃(Al, Ga)₅O₁₂:Ce), a CCA-based phosphor (e.g., Ca₁₀(PO₄)₆Cl₂:Eu), an SAE-based phosphor (e.g., Sr₄Al₁₄O₂₅:Eu), a chlorosilicate-based phosphor (e.g., Ca₈MgSi₄O₁₆C_{I2}:Eu), a nitride-based phosphor such as a β-sialon-based phosphor (e.g., (Si, Al)₃(O, N)₄:Eu), an α-sialon-based phosphor (e.g., Ca(Si, Al)₁₂(O, N)₁₆:Eu), an SLA-based phosphor (e.g., SrLiAl₃N₄:Eu), a CASN-based phosphor (e.g., CaAlSiN₃:Eu), a SCASN-based phosphor (e.g., (Sr, Ca)AlSiN₃:Eu), or the like, a fluoride-based phosphor such as a KSF-based phosphor (e.g., K₂SiF₆:Mn), a KSAF-based phosphor (e.g., K₂(Si, Al)F₆:Mn), a MGF-based phosphor (e.g., 3.5MgO·0.5MgF₂·GeO₂:Mn), or the like, a phosphor having a perovskite structure (e.g., CsPb(F, Cl, Br, I)₃), a quantum dot phosphor (e.g., CdSe, InP, AgInS₂, or AgInSe₂), etc.

### 1.3 Light-emitting element 30

The light-emitting element 30 is a semiconductor element that emits light when a voltage is applied, and a known semiconductor element that includes a nitride semiconductor or the like is applicable to the light-emitting element 30. Examples of the light-emitting element 30 include an LED chip. The light-emitting element 30 includes a semiconductor stacked body. The semiconductor stacked body includes an n-type semiconductor layer, a p-type semiconductor layer, and a light-emitting layer interposed between the n-type semiconductor layer and the p-type semiconductor layer. The light-emitting layer may have a double heterojunction structure, a single quantum well (SQW) structure, or the like, or a structure having an active layer group such as a multi-quantum well (MQW) structure. The semiconductor stacked body is configured to be able to emit visible light or ultraviolet light. A semiconductor stacked body that includes such a light-emitting layer can include, for example, In*ₓ*Al_{y}Ga_{1-x-*y*}N (0 ≤ *x*, 0 ≤ *y*, and *x* + *y* ≤ 1).

The semiconductor stacked body may have a structure including an n-type semiconductor layer, a p-type semiconductor layer, and one or more light-emitting layer between the n-type semiconductor layer and the p-type semiconductor layer, or a structure in which multiple structures including an n-type semiconductor layer, a light-emitting layer, and a p-type semiconductor layer are repeated in this order. When the semiconductor stacked body includes multiple light-emitting layers, the multiple light-emitting layers may include light-emitting layers having different light emission peak wavelengths, or may include light-emitting layers having the same light emission peak wavelength. The light emission peak wavelength being the same also includes cases where there is variation within ±10 nm. Combinations of light emission peak wavelengths of the multiple light-emitting layers can be selected as appropriate. For example, when the semiconductor stacked body includes two light-emitting layers, the light-emitting layers can be selected with combinations of blue light and blue light, green light and green light, red light and red light, ultraviolet light and ultraviolet light, blue light and green light, blue light and red light, green light and red light, etc. Each light-emitting layer may include multiple active layers having different light emission peak wavelengths, or may include multiple active layers having the same light emission peak wavelength.

Only one light-emitting element 30 may be placed in one light-emitting device 100, or multiple light-emitting elements 30 may be placed in one light-emitting device 100. When one light-emitting device 100 includes multiple light-emitting elements 30, a combination of multiple light-emitting elements having the same light emission peak wavelength may be used to improve the luminous intensity of the entire light-emitting device. For example, the color gamut as a backlight light source can be increased by combining multiple light-emitting elements 30 having different light emission peak wavelengths to correspond to red, green, and blue.

When the light-emitting device 100 includes multiple light-emitting elements 30, all of the light-emitting elements may be connected in series, parallel, or a combination of series and parallel. The light-emitting element 30 may be placed with the surface on which the electrodes are formed facing upward, or may be flip-chip mounted so that the surface on which the electrodes are formed faces downward. The light-emitting element 30 of the light-emitting device 100 is placed with the surface on which the electrodes are formed facing upward, and the light-emitting element 30 is electrically connected with the conductive member 32 of the substrate via wires 31.

The light-emitting element 30 may be a quadrilateral such as a square, a rectangle, etc., in a plan view, and the light-emitting element 30 may be placed on the placement surface 21a of the substrate 20 so that one side of the quadrilateral is parallel to the X-direction or the Y-direction, or so that one side of the quadrilateral shape is oblique to the X-direction and Y-direction. Compared to when the light-emitting element 30 is placed on the placement surface 21a of the substrate 20 so that one side of the quadrilateral shape is parallel to the X-direction or the Y-direction in a plan view, the light distribution characteristics of the light-emitting device 100 can be changed by placing the light-emitting element 30 on the placement surface 21a of the substrate 20 so that one side of the quadrilateral shape of the light-emitting element 30 is oblique to the X-direction and Y-direction in a plan view. For example, one side of the quadrilateral shape of the light-emitting element 30 may be at an angle of not less than 35° and not more than 60° with respect to the X-direction in a plan view. Each light-emitting device 100 may include two or more rectangular light-emitting elements 30 in a plan view.

### 1.4 Light-shielding member 40

The light-shielding member 40 shields at least a portion of the light emitted from the light-emitting element 30. The light-shielding member 40 has a lower transmittance than the light-transmitting member 10 with respect to the peak wavelength of the light-emitting element 30. For example, the light-shielding member 40 has a transmittance with respect to the peak wavelength of the light-emitting element 30 of not more than 40%. The light-shielding member 40 covers the upper surface 30a of the light-emitting element 30 with the light-transmitting member 10 interposed. As a result, a portion of the light traveling in the upward direction from the light-emitting element 30 is shielded by the light-shielding member 40, and so the light emitted from the light-emitting device 100 tends to be larger in the lateral directions (the X-direction and/or the Y-direction) than in the upward direction (the Z-direction).

At least a portion of the light-emitting element 30 overlaps the light-shielding member 40 in a plan view. The entirety of each of the light-emitting elements 30 included in the light-emitting device 100 preferably overlaps the light-shielding member 40 in a plan view. As a result, a portion of the light traveling in the upward direction from the light-emitting element 30 is easily shielded. As a result, the light emitted from the light-emitting device 100 tends to be large in the lateral direction. The light-shielding member 40 may transmit a portion of the light. The light-shielding member 40 may reflect the light from the light-emitting element 30 or may absorb the light from the light-emitting element 30. The light-shielding member 40 is preferably reflective. As a result, the light extraction efficiency of the light-emitting device 100 is increased because the light from the light-emitting element 30 is not easily absorbed by the light-shielding member 40.

The material of the light-shielding member 40 may include a metal or a resin material including a light-reflective substance. When the light-shielding member 40 is a metal, for example, aluminum or the like can be used. When a resin material is used as the base material of the light-shielding member 40, a resin material same as or similar to that of the light-transmitting member 10 can be used. Similarly to the light-transmitting member 10, titanium oxide, zinc oxide, silicon oxide, zirconium oxide, aluminum oxide, aluminum nitride, etc., can be used as the light-reflective substance. For example, the ratio of the light-reflective substance to the resin material can be not less than 10 weight% and not more than 90 weight%. A resin member may include a reflector; in such a case, examples of the resin member include a polyethylene terephthalate (PET) resin, an olefin resin, an acrylic resin, a silicone resin, a urethane resin, an epoxy resin, etc. Examples of the reflector include gases such as air, etc. Examples of other materials of the reflector include particles of silicon dioxide, calcium fluoride, magnesium fluoride, etc.

Although not particularly limited, it is preferable for the difference between the linear expansion coefficient of the base material of the light-transmitting member 10 and the linear expansion coefficient of the base material of the light-shielding member 40 to be within 30 ppm/°C. As a result, detachment of the light-shielding member 40 from the light-transmitting member 10 can be suppressed. For example, a phenyl silicone resin may be used as the base material of the light-shielding member 40 when a phenyl silicone resin is used as the base material of the light-transmitting member 10. The light-transmitting member 10 and the light-shielding member 40 may contact each other, or a known bonding member may be positioned between the light-transmitting member 10 and the light-shielding member 40.

### 1.5 Protection element 50

The light-emitting device 100 includes the protection element 50. The protection element 50 includes, for example, an element part and a positive and negative pair of electrodes located at the lower surface of the element part, and the protection element 50 is connected in parallel with the light-emitting element 30. When the protection element 50 is a Zener diode or the like that has polarity, the protection element 50 is connected in the reverse direction of the light-emitting element 30. When the protection element 50 is a varistor or the like that has no polarity, the protection element 50 is connected in the forward direction or the reverse direction of the light-emitting element 30. The element part of the protection element 50 may be a rectangular parallelepiped with a pair of electrodes located at one surface of the element part. A Zener diode, a varistor, etc., are examples of the protection element 50 including electrodes having such a shape.

The role of the protection element 50 is to reduce the voltage load applied between the positive and negative electrodes of the light-emitting element 30 when an excessive voltage load is applied to the light-emitting device 100 by bypassing current by reducing the resistance of a parallel circuit including the protection element 50. For example, a drive circuit that includes the light-emitting element 30 and a bypass circuit that includes the protection element 50 are formed by connecting the light-emitting element 30 and the protection element 50 in parallel in reverse directions. When the protection element 50 operates, the bypass circuit, which has low resistance, can reduce the current shunted to the light-emitting element 30 connected in parallel with the protection element 50. For example, when the light-emitting device 100 is mounted on the wiring substrate, the resistance of the bypass circuit can be reduced by shortening the distance between the protection element 50 and the wiring part of the wiring substrate, that is, shortening the path of the bypass circuit. As a result, the load on the light-emitting element 30 can be reduced, and the protection effect of the light-emitting element 30 can be further increased.

### 1.6 Sectional Summary

Thus, according to the embodiment, the light-emitting device 100 includes the substrate 20, the light-emitting element 30 placed on the substrate 20, the light-transmitting member 10 placed to cover the light-emitting element 30, and the light-shielding member 40 that is located on the light-transmitting member 10 and shields at least a portion of the light emitted from the light-emitting element 30. The light-transmitting member 10 includes the upper surface 11 at which the light-shielding member 40 is placed, and the lateral surface 12 that includes the inclined portion 12a connected to the upper surface 11. The substrate 20 includes the wall part 22 that is positioned lateral side of the light-emitting element 30 and includes the upper end 22a positioned lower than the upper surface 30a of the light-emitting element 30. By such a configuration, a portion of the light emitted from the light-emitting element 30 and exiting from the upper surface 11 of the light-transmitting member 10 can be shielded by the light-shielding member 40 and exiting from the inclined portion 12a of the light-transmitting member 10, and a light-emitting device 100 that has a wide light distribution can be achieved. Herein, "wide light distribution" refers to light distribution characteristics in which the luminous intensity peaks in a range of light distribution angles between 0° and ±90° are greater than the luminous intensity at a light distribution angle of 0°.

In the light-emitting device 100, the area of the lower surface 41 of the light-shielding member 40 is substantially equal to the area of the upper surface 11 of the light-transmitting member 10 in a plan view. By using such a configuration, substantially all of the light exiting from the upper surface 11 of the light-transmitting member 10 can strike the light-shielding member 40, while the light that is emitted from the light-emitting element 30 and exits from the inclined portion 12a of the light-transmitting member 10 can be extracted at a desired angle.

In the light-emitting device 100, the lateral surface 12 of the light-transmitting member 10 may include the inclined portion 12a that is connected to the upper surface 11 of the light-transmitting member 10, and the lateral portion 12b that is vertical or has a larger inclination angle than the inclined portion 12a. By using such a configuration, the angle of the inclined portion 12a of the light-emitting device 100 can be adjusted, and the distribution of the light exiting from the inclined portion 12a can be adjusted.

In the light-emitting device 100, the wall part 22 may include the inner lateral surface 22b facing the light-emitting element 30, and the outer lateral surface 22c forming the lateral surface of the substrate 20 located opposite to the inner lateral surface 22b, and the inner lateral surface 22b of the wall part 22 may be inclined away from the light-emitting element 30 as the height of the inner lateral surface 22b increases. By using such a configuration, the light that is emitted from the light-emitting element 30 is diffusely reflected by the inner lateral surface 22b of the wall part 22 and travels toward the light-shielding member 40. A portion of the diffusely reflected light also is diffusely reflected by the light-shielding member. The light that is diffusely reflected by the light-shielding member exits from the lateral portion of the light-transmitting member, and the light-emitting device 100 that has a wide light distribution can be achieved. Compared to a light-emitting device that does not include the wall part 22, the ratio of the light exiting from the inclined portion of the light-transmitting member can be increased among the lateral portion and the inclined portion of the light-transmitting member.

In the light-emitting device 100, the wall part 22 may surround the light-emitting element 30. By using such a configuration, the light that is emitted from the light-emitting element 30 can be diffusely reflected at the inner lateral surface 22b of the wall part 22.

In the light-emitting device 100, the protection element 50 may be located on the substrate 20, and an upper surface 50a of the protection element 50 may be positioned lower than the upper end 22a of the wall part 22. By using such a configuration, the light-emitting device 100 that has a wide light distribution can be achieved for the light-emitting device 100 that includes the protection element 50.

### 1.7 Modifications

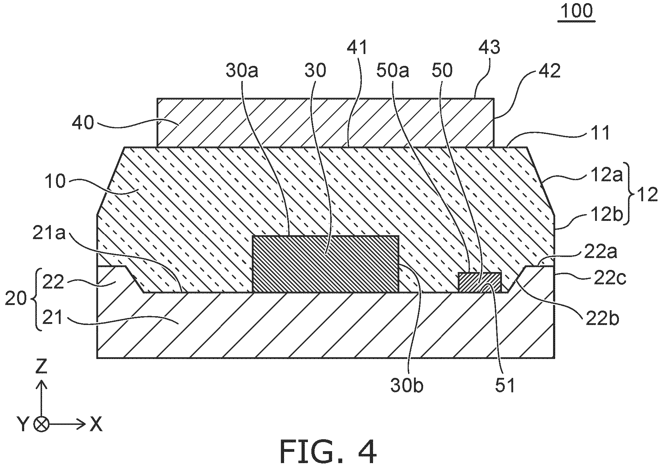

Modifications of the first embodiment will now be described with reference to FIGS. 3 and 4.

FIG. 3 is a schematic cross-sectional view along the XZ-plane of a light-emitting device according to a modification 1.

FIG. 4 is a schematic cross-sectional view along the XZ-plane of a light-emitting device according to a modification 2.

In the light-emitting device 100 according to the modification 1 as shown in FIG. 3, the area of the lower surface 41 of the light-shielding member 40 is greater than the area of the upper surface 11 of the light-transmitting member 10 in a plan view. Preferably, the area of the lower surface 41 of the light-shielding member 40 is equal to the area of the light-transmitting member 10 at the boundary between the lateral portion 12b and the inclined portion 12a in a plan view. Preferably, the shape of the lower surface 41 of the light-shielding member 40 is similar to the shape of the upper surface 11 of the light-transmitting member 10 in a plan view, and the length of the outer perimeter of the lower surface 41 of the light-shielding member 40 is greater than the length of the contour of the upper surface 11 of the light-transmitting member 10. By such a configuration, a portion of the light that is emitted from the light-emitting element 30 and exits from the inclined portion 12a of the light-transmitting member 10 can strike the light-shielding member 40, and the direction in which the light travels can be changed.

In the light-emitting device 100 according to the modification 2 as shown in FIG. 4, the area of the lower surface 41 of the light-shielding member 40 is less than the area of the upper surface 11 of the light-transmitting member 10 in a plan view. Preferably, the shape of the lower surface 41 of the light-shielding member 40 is similar to the shape of the upper surface 11 of the light-transmitting member 10 in a plan view, and the length of the outer perimeter of the lower surface 41 of the light-shielding member 40 is less than the length of the contour of the upper surface 11 of the light-transmitting member 10. By such a configuration, a portion of the light that is emitted from the light-emitting element 30 and passes through the upper surface 11 of the light-transmitting member 10 can strike the light-shielding member 40 while the remaining portion of the light can be transmitted, and the light distribution characteristics can be adjusted. The area of the lower surface 41 of the light-shielding member 40 is preferably greater than the area of the upper surface 30a of the light-emitting element 30 in a plan view.

### 2. Second embodiment

In the substrate 20 according to the first embodiment above, the wall part 22 is formed of one wall part 22, of which the outer lateral surface is coplanar with the outer lateral surface of the base part and surrounds the light-emitting element 30; however, the substrate 20 is not limited to such a configuration.

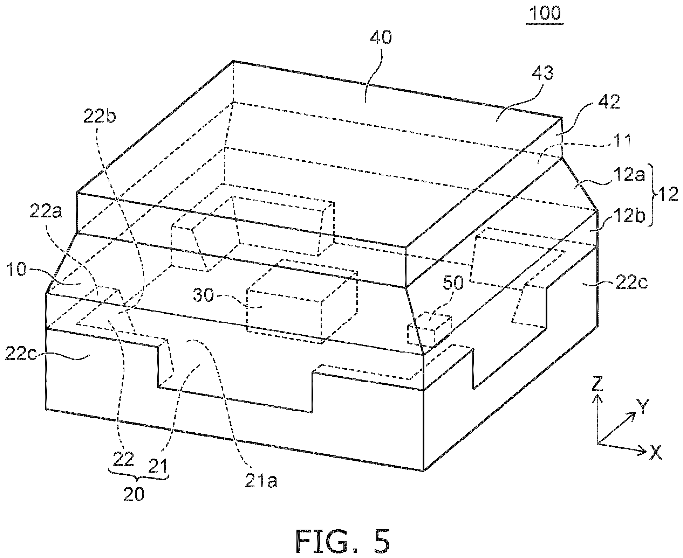

FIG. 5 is a schematic perspective view of a light-emitting device according to a second embodiment.

For example, as shown in FIG. 5, the wall part 22 may be located at only four corners of the substrate 20. Effects similar to those of the first embodiment also can be obtained for such a configuration. A portion of the light traveling from the light-emitting element in directions parallel to the XY-plane can be diffusely reflected at the corners of the substrate, and when comparing the light exiting from the corners of the substrate and the light exiting from a region between two adjacent corners, the light exiting from the region between two adjacent corners can propagate farther in directions parallel to the XY-plane. Also, other than the light-emitting device of FIG. 5, for example, a light-emitting device is possible in which the wall part 22 is located between two adjacent corners and no wall part 22 is located at the four corners of the substrate 20. In such a case, light exiting from the four corners can propagate farther in directions parallel to the XY-plane.

### 3. Third embodiment

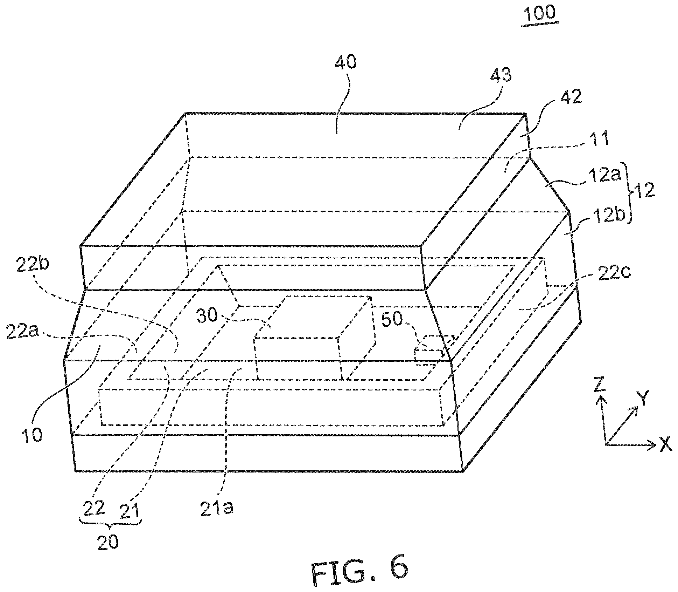

FIG. 6 is a schematic perspective view of a light-emitting device according to a third embodiment.

As shown in FIG. 6, the wall part 22 may be located inside and along the outer perimeter of the substrate 20. As a result, the distribution of the light emitted from the light-emitting element 30 can be adjusted. Also, the contact area of the light-transmitting member with the substrate can be increased, and the adhesion between the substrate and the light-transmitting member is improved.

Although the light-shielding member 40 according to the first to third embodiments above has a quadrilateral plate shape in a plan view, the light-shielding member 40 is not limited to such a configuration. For example, the light-shielding member 40 may be formed in a frustum shape. In such a case, the lateral surface 42 of the light-shielding member 40 and the inclined portion 12a of the light-transmitting member 10 may be formed to be coplanar.

Although the inclined portion 12a of the light-transmitting member 10 according to the first to third embodiments above is a plane, the inclined portion 12a is not limited to such a configuration. For example, the inclined portion 12a may include a curved surface protruding outward of the light-transmitting member 10, or may include a curved surface protruding inward of the light-transmitting member 10.

### 4. Fourth embodiment

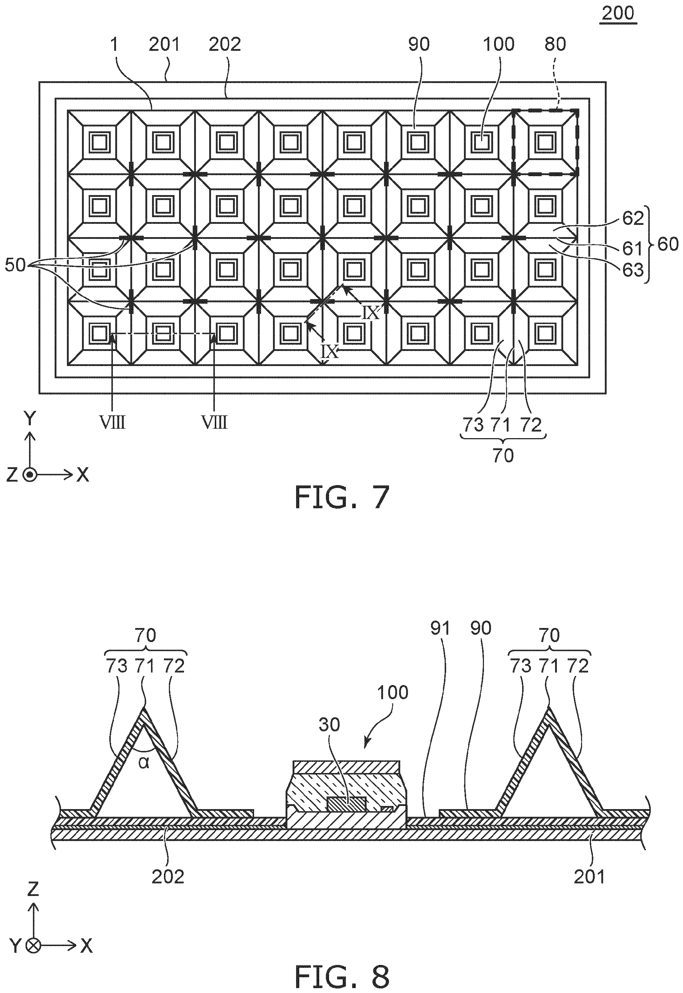

A fourth embodiment of the disclosure will now be described with reference to FIGS. 7 to 9.

FIG. 7 is a plan view illustrating a planar light source according to the fourth embodiment.

FIG. 8 is a cross-sectional view along line VIII-VIII of FIG. 7.

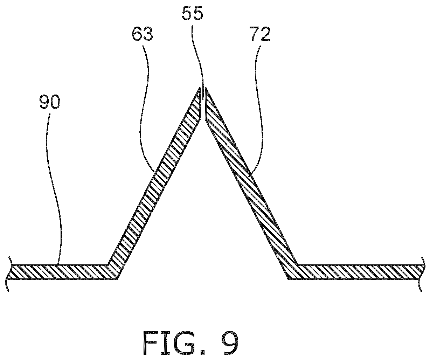

FIG. 9 is a cross-sectional view along line IX-IX of FIG. 7.

As shown in FIGS. 7 and 8, the planar light source 200 includes a base body 201, a covering member 202, a partitioning member 1, and multiple light-emitting devices 100. The partitioning member 1 is located on the base body 201. The covering member 202 covers at least a portion of the upper surface of the base body 201. The covering member 202 is provided as necessary.

The partitioning member 1 includes multiple first wall parts 60, multiple second wall parts 70, and multiple partitioning regions 80. For example, the multiple first wall parts 60 are placed parallel to each other. For example, the multiple second wall parts 70 are placed parallel to each other. The partitioning member 1 may include multiple bottom parts 90 as necessary. The first wall part 60 includes a first ridge 61 extending in a first direction, a first sidewall 62, and a second sidewall 63. The first sidewall 62 and the second sidewall 63 are placed with the first ridge 61 interposed in a plan view. The upper end of the first sidewall 62 and the upper end of the second sidewall 63 are continuous. There is a space between the first sidewall 62 and the second sidewall 63.

The second wall part 70 of the partitioning member 1 includes a second ridge 71 extending in a second direction, a third sidewall 72, and a fourth sidewall 73. The third sidewall 72 and the fourth sidewall 73 are placed with the second ridge 71 interposed therebetween in a plan view. The upper end of the third sidewall 72 and the upper end of the fourth sidewall 73 are continuous. There is a space between the third sidewall 72 and the fourth sidewall 73.

As shown in FIG. 9, the partitioning member 1 partially includes a gapped portion 55 on the first ridge 61 and on the second ridge 71. The gapped portion 55 may be provided as appropriate, and the gapped portion 55 that is parallel to the X-direction and the gapped portion 55 that is parallel to the Y-direction may be provided alternately as shown in FIG. 9.

In the planar light source 200, the lower surface of the bottom part 90 of the partitioning member 1 is located on the covering member 202 located on the base body 201. That is, the lower surface of the bottom part 90 of the partitioning member 1 is provided indirectly on the base body 201 with the covering member 202 interposed. In the planar light source 200, the light-emitting device 100 is located on a portion of the base body 201 exposed inside an opening 91 of the bottom part 90. Members included in the planar light source 200 will now be elaborated.

### 2.1 Base body 201

The base body 201 is a member on which the multiple light-emitting devices 100 is placed. The conductive member 32 for supplying power to the light-emitting device 100 is located at the upper surface of the base body 201. The covering member 202 preferably covers a portion of the conductive member 32 not electrically connected with the light-emitting element.

It is sufficient for the material of the base body 201 to be able to insulatively isolate at least the conductive member 32, and examples of the material of the base body 201 include, for example, a ceramic, a resin, a composite material, etc. Examples of the resin include a phenol resin, an epoxy resin, a polyimide resin, a BT resin, polyphthalamide (PPA), polyethylene terephthalate (PET), etc. Examples of the composite material include the resin described above into which an inorganic filler such as glass fibers, silicon oxide, titanium oxide, aluminum oxide, etc., is mixed, a glass fiber-reinforced resin (a glass epoxy resin), a metal substrate in which an insulating layer covers the metal member, etc.

The thickness of the base body 201 can be selected as appropriate. The base body 201 may be any flexible substrate or rigid substrate that can be manufactured using a roll-to-roll method. The rigid substrate may be a bendable thin rigid substrate. The material of the conductive member 32 is not particularly limited as long as the conductive member 32 is conductive, and a material that is normally used as a wiring layer of a circuit board, etc., can be used.

The covering member 202 preferably include an insulating material. Examples of the material of the covering member 202 include materials same as or similar to those illustrated as the material of the base body 201. By using the resin described above that includes an inorganic filler such as titanium oxide, aluminum oxide, silicon oxide, etc., as the covering member 202, the light that is emitted from the light-emitting device 100 can be reflected, and the light extraction efficiency of the planar light source 200 can be increased.

### 2.2 Light-emitting device 100

For example, the light-emitting device 100 described in the first embodiment is used as the light-emitting device. The light-emitting device 100 may include one light-emitting element 30, or one light-emitting device 100 may include multiple light-emitting elements. For example, the light-emitting device 100 may be a light-emitting device that emits white light.

By using a light-emitting device that obtains a wide light distribution as the light-emitting device 100, the light intensity that is emitted directly upward from the light-emitting device 100 can be reduced, and the uneven luminance of the partitioning regions 80 can be suppressed by spreading the light distribution of each light-emitting device 100 and by irradiating the light that is spread on the first sidewall 62, the second sidewall 63, the third sidewall 72, the fourth sidewall 73, and the bottom part 90.

It is favorable for the multiple light-emitting devices 100 to be wired on the base body 201 to be independently drivable and to have dimming control (e.g., local dimming or a high dynamic range) for each light-emitting device 100.

### 2.3 Partitioning member 1

The partitioning member 1 is located on the base body 201. There is a space between the lower surface of the first sidewall 62 and the upper surface of the base body 201 or the upper surface of the covering member 202 and between the lower surface of the second sidewall 63 and the upper surface of the base body 201 or the upper surface of the covering member 202. Also, there is a space between the lower surface of the third sidewall 72 and the upper surface of the base body 201 or the upper surface of the covering member 202 and between the lower surface of the fourth sidewall 73 and the upper surface of the base body 201 or the upper surface of the covering member 202.

In the partitioning member 1, the openings 91 are located respectively at the central portions of the partitioning regions 80. It is sufficient for the shape and size of each opening 91 to be such that the entire light-emitting device 100 is exposed, and it is preferable to set the outer edge of each opening 91 to be positioned only at the vicinity of the light-emitting device 100. As a result, when the partitioning member 1 is light-reflective, the light from the light-emitting device 100 can also be reflected by the bottom parts 90, and the light extraction efficiency can be increased.

In FIG. 8, it is preferable for an angle α formed by the adjacent third sidewall 72 and fourth sidewall 73 to be, for example, 60 degrees to 90 degrees. By setting the angle α in such a range, the space and region occupied by the partitioning member 1 can be reduced, the height of the partitioning member 1 can be reduced, and the planar light source 200 can be thinned. This is similar for the angle formed by the adjacent first sidewall 62 and second sidewall 63 as well.

The pitch between the adjacent first ridges 61 and the pitch between the adjacent second ridges 71 can be appropriately adjusted according to the size of the light source used, the intended size of the planar light source, etc. Examples of the pitch between the adjacent first ridges 61 and the pitch between the adjacent second ridges 71 include, for example, 1 mm to 50 mm, preferably 5 mm to 20 mm, and more preferably 6 mm to 15 mm.

It is preferable for a height H of the partitioning member 1 itself, that is, the Z-direction length from the lower surface of each bottom part 90 of the partitioning member 1 to the first ridge 61 or the second ridge 71, to be not more than 8 mm, and for an even thinner planar light source, preferably about 1 mm to 4 mm.

It is preferable to bond the partitioning member 1 to the base body 201 or to the covering member on the upper surface of the base body 201 by using a bonding member. As a result, even when the partitioning member 1 tends to contract due to heat, the contraction of the partitioning member 1 can be suppressed because the partitioning member 1 is bonded with the base body 201 via the bonding member. In the partitioning member 1, the periphery of each opening 91 can be bonded using a light-reflective bonding member so that the light emitted from the light-emitting device 100 is not incident between the base body 201 and the partitioning member 1. For example, it is more preferable to provide a light-reflective bonding member in a ring shape along the outer edge of each opening 91. The bonding member may be, for example, double-sided tape in which an acrylic resin pressure-sensitive adhesive is located on two surfaces of a PET base member, a hot melt adhesive sheet, or a resin-based adhesive such as a thermosetting resin, a thermoplastic resin, etc. It is preferable for these bonding members to have high flame retardance.

As described above, it is preferable for the partitioning member 1 to be light-reflective. As a result, the light that is emitted from the light-emitting device 100 can be reflected efficiently in the upward direction by the first sidewall 62, the second sidewall 63, the third sidewall 72, the fourth sidewall 73, and the bottom part 90.

The partitioning member 1 may include a resin or the like including a reflective member formed of particles of titanium oxide, aluminum oxide, silicon oxide, etc., or may include a resin that does not include a reflective member but has a reflective member provided on the surface of the resin. Alternatively, a resin that includes multiple fine bubbles may be used. In such a case, light is reflected by the interfaces between the resin and the bubbles. Examples of the resin included in the partitioning member 1 include an acrylic resin, a polycarbonate resin, a cyclic polyolefin resin, a polyethylene terephthalate, polyethylene naphthalate, polyester, or other thermoplastic resin, a thermosetting resin such as an epoxy resin, a silicone resin, etc. It is preferable to set the reflectance of the partitioning member 1 to the light emitted from the light-emitting device 100 to be not less than 70%.

The partitioning member 1 may be formed by a molding method using a mold, a molding method using stereolithography, etc.. Alternatively, a partitioning member 1 that includes the first wall parts 60, the second wall parts 70, and the bottom parts 90 may be otherwise procured. Molding methods such as injection molding, extrusion, compression molding, vacuum forming, pressing, etc., are applicable as the molding method using a mold. For example, the partitioning member 1 in which the first wall parts 60, the second wall parts 70, and the bottom parts 90 are molded as one piece can be obtained by vacuum forming using a reflective sheet including PET, etc.

The planar light source 200 can include a diffusion sheet as an optical member located above the light-emitting device 100 with the partitioning member 1 interposed. When, for example, a light-emitting device emitting blue light is used instead of a light-emitting device emitting white light, an optical sheet that includes a wavelength conversion member may also be included on the diffusion sheet. The materials described for the wavelength conversion member included in the light-transmitting member 10 can be used here as the wavelength conversion member.

The planar light source 200 may have a shape that is parallel to the X-Y plane, or may have a shape that is curved toward the +Z side or the -Z side with respect to the X-Y plane. For example, the center of the planar light source 200 in the X-direction may have a curved shape that is recessed in the -Z side.

Hereinabove, embodiments of the invention are described with reference to specific examples. However, the invention is not limited to these specific examples. All configurations practicable by an appropriate design modification by one skilled in the art based on the embodiments of the disclosure described above also are within the scope of the invention to the extent that the spirit of the disclosure is included. Various modifications and alterations within the spirit of the invention will be readily apparent to those skilled in the art. All such modifications and alterations should therefore be seen as within the scope of the invention.

## Claims

1. A light-emitting device comprising:
a substrate;
a light-emitting element located on the substrate;
a light-transmitting member covering the light-emitting element; and
a light-shielding member located on the light-transmitting member, the light-shielding member shielding at least a portion of light emitted from the light-emitting element; wherein:
the light-transmitting member includes:
an upper surface on which the light-shielding member is located, and
a lateral surface including an inclined portion, the inclined portion being connected to the upper surface,
the substrate comprises a wall part positioned at a lateral side of the light-emitting element; and
an upper end of the wall part is positioned lower than an upper surface of the light-emitting element.

2. The light-emitting device according to claim 1, wherein:
in a plan view, an area of a lower surface of the light-shielding member is greater than an area of the upper surface of the light-transmitting member.

3. The light-emitting device according to claim 1, wherein:
in a plan view, an area of a lower surface of the light-shielding member is substantially equal to an area of the upper surface of the light-transmitting member.

4. The light-emitting device according to claim 1, wherein:
in a plan view, an area of a lower surface of the light-shielding member is less than an area of the upper surface of the light-transmitting member

5. The light-emitting device according to any of claims 1 to 4, wherein:
the lateral surface of the light-transmitting member includes, in addition to the inclined portion connected to the upper surface of the light-transmitting member, a lateral portion that is vertical or has an inclination angle larger than the inclined portion.

6. The light-emitting device according to any of claims 1 to 5, wherein:
the wall part includes:
an inner lateral surface facing the light-emitting element, and
an outer lateral surface located opposite to the inner lateral surface, the outer lateral surface forming a lateral surface of the substrate; and
the inner lateral surface of the wall part is inclined away from the light-emitting element as a height of the inner lateral surface increases.

7. The light-emitting device according to any of claims 1 to 6, wherein:
the wall part surrounds the light-emitting element.

8. The light-emitting device according to any of claims 1 to 7, further comprising:
a protection element located on the substrate; wherein:
an upper surface of the protection element is positioned lower than the upper end of the wall part.

9. A planar light source comprising:
a substrate;
a plurality of light-emitting devices located on the substrate; and
at least one partitioning member located on the substrate, the partitioning member comprising:
a plurality of first wall parts, each of the plurality of first wall parts comprising a first ridge extending in a first direction,
a plurality of second wall parts, each of the plurality of second wall parts comprising a second ridge extending in a second direction, the second direction crossing the first direction, and
a partitioning region comprising two opposing first wall parts among the plurality of first wall parts and two opposing second wall parts among the plurality of second wall parts, the partitioning region being surrounded with the first and second ridges in a plan view; wherein:
a plurality of the partitioning regions are located in the first and second directions;
at least one first gapped portion is provided on at least one of the first ridges;
the plurality of light-emitting devices are respectively located inside the plurality of partitioning regions;
each of the plurality of light-emitting devices comprises:
a light-emitting element located on the substrate,
a light-transmitting member covering the light-emitting element, and
a light-shielding member located on the light-transmitting member, the light-shielding member shielding at least a portion of light emitted from the light-emitting element;
the light-transmitting member comprises:
an upper surface on which the light-shielding member is located, and
a lateral surface including an inclined portion, the inclined portion being connected to the upper surface;
the substrate comprises a wall part positioned at a lateral side of the light-emitting element; and
an upper end of the wall part of the substrate is positioned lower than an upper surface of the light-emitting element.

10. The light-emitting device according to claim 9, wherein:
the wall part of the substrate includes:
an inner lateral surface facing the light-emitting element, and
an outer lateral surface located opposite to the inner lateral surface, the outer lateral surface forming a lateral surface of the substrate; and
the inner lateral surface of the wall part of the substrate is inclined away from the light-emitting element as a height of the inner lateral surface increases.
